# FASCICULE DE BREVET EUROPEEN

(11) **EP 3 722 253 B1**
(45) Date de publication et mention de la délivrance du brevet: **15.12.2021**
(21) Numéro de dépôt: 20168233.3
(22) Date de dépôt: 06.04.2020
(51) Int. Cl.: B81B 3/00

(54) **CHARNIERE HORS-PLAN POUR STRUCTURE MICROMECANIQUE ET/OU NANOMECANIQUE A SENSIBILITE AUX CONTRAINTES INTERNES REDUITE**
SCHARNIER AUSSERHALB DER EBENE FÜR MIKRO- UND/ODER NANOMECHANISCHE STRUKTUR MIT EINER REDUZIERTEN EMPFINDLICHKEIT GEGENÜBER INNENSPANNUNGEN
OUT-OF-PLANE HINGE FOR MICROMECHANICAL AND/OR NANOMECHANICAL STRUCTURE WITH REDUCED SENSITIVITY TO INTERNAL CONSTRAINTS

(30) Priorité: 08.04.2019 FR 1903730
(43) Date de publication de la demande: 14.10.2020
(73) Titulaire: Commissariat à l'énergie atomique et aux énergies alternatives, 75015 Paris (FR)
(72) Inventeur: REY, Patrice, 38054 GRENOBLE CEDEX 09 (FR); JOET, Loic, 38054 GRENOBLE CEDEX 09 (FR); VERDOT, Thierry, 38054 GRENOBLE CEDEX 09 (FR)
(74) Mandataire: Brevalex

(56) Documents cités:
- FR-A1- 2 983 844
- US-A1- 2014 300 942

## Description

### DOMAINE TECHNIQUE ET ÉTAT DE LA TECHNIQUE ANTÉRIEURE

La présente invention se rapporte à une charnière hors-plan pour structure micro et/ou nanomécanique, notamment pour système microélectromécanique, offrant une sensibilité aux contraintes internes réduite. Les

systèmes microélectromécaniques ou MEMS (microelectromechanical systems en terminologie anglo-saxonne) et les systèmes micro et nanoélectromécaniques ou systèmes M&NEMS (micro & nanoelectromechanical systems en terminologie anglo-saxonne) sont utilisés pour réaliser des capteurs ou des actionneurs. Ils comportent au moins un élément mobile par rapport à un substrat. Par exemple dans le cas d'un capteur, le déplacement de la partie mobile ou masse est mesurée et peut être traduit en une caractéristique à détecter, par exemple une accélération, et dans le cas d'un actionneur, l'élément mobile est déplacé par exemple au moyen de forces électrostatiques, par exemple pour déplacer un micromiroir.

L'élément mobile est suspendu par rapport au substrat et suivant les applications on peut souhaiter qu'il ait un déplacement dans le plan du système ou un déplacement hors-plan, i.e. orthogonalement au plan du système.

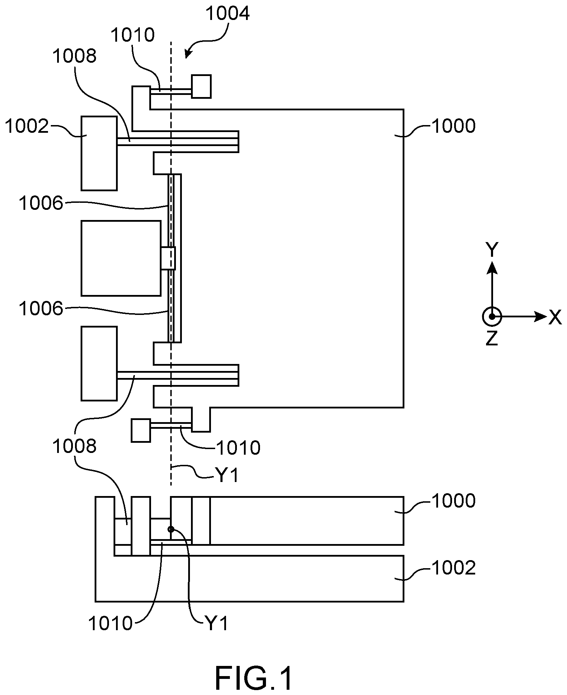

Sur la figure 1, on peut voir un exemple d'une structure microélectromécanique de l'état de la technique décrit dans le document FR 2 983 844.

La structure s'étendant dans le plan XY, comporte une masse 1000 apte à se déplacer dans une direction hors-plan Z par rapport à un support 1002. La structure comporte une charnière 1004 formant une articulation en rotation 1004 entre le support 1002 et la masse 1000, la charnière présentant un axe de rotation Y1 dans le plan. La charnière relie un bord de la masse au support, et comporte deux poutres 1006 destinées à être sollicitées en torsion et coaxiales à l'axe de rotation et deux poutres 1008 destinées à être sollicitées en flexion et orthogonales à l'axe de rotation. Les poutres 1006 et 1008 relient la masse au support. Cette structure comporte également deux jauges piézorésistives 1010 permettant de mesurer le déplacement de la masse. Les poutres de flexion 1008 ont pour fonction de rigidifier l'articulation dans la direction X. Cependant elles provoquent également une rigidification de l'articulation dans la direction hors-plan, ce qui n'est pas souhaitable. Afin de réduire leur effet sur la rigidité dans la direction Z, l'épaisseur des poutres de flexion est réduite.

Une telle structure est réalisée par les procédés de la microélectronique mettant en œuvre des dépôts, des gravures et une libération de la masse. Par exemple la structure est réalisée par gravure dans une couche formée par épitaxie sur un substrat Silicium sur Isolant ou SOI (Silicon on Insulate) et la masse est libérée en gravant la couche d'oxyde enterrée du substrat SOI.

Lors de la réalisation de la couche par épitaxie, des contraintes sont générées dans la couche. Ces contraintes peuvent notamment être dues au dopage. Par exemple, les atomes de bore sont plus petits que ceux de silicium et induisent une contrainte en compression dans la maille cristalline du silicium. Cette contrainte peut aussi apparaître avant l'épitaxie, lors du dopage de la couche fine du substrat SOI. Lors de la libération de la structure par gravure, ces contraintes dans toutes les couches sont au moins en partie libérées. Or cette libération des contraintes génère un nouvel équilibre des forces et des moments qui peut conduire à une déformation de la structure. Les poutres de flexion sont formées dans la couche épitaxiée. Lors de la libération de la structure, les contraintes dans les poutres se détendent/ se rétractent. Or les jauges, qui sont parallèles aux poutres de flexion, s'opposent à l'expansion/ la rétraction des poutres de flexion. Les poutres de flexion et les jauges étant dans des plans différents, la masse s'incline. Elle n'est alors plus perpendiculaire à l'axe Z. Lorsque les contraintes internes proviennent de la couche fine du substrat SOI, les jauges 1010 n'étant pas alignées, elles vont induire un couple sur la masse et la faire tourner dans le plan. De plus, les contraintes internes de la couche inférieure des poutres de flexion les font fléchir, provoquant une inclinaison de la masse.

Une déformation de la structure peut également survenir lors de la libération de contraintes dans le substrat SOI.

La contrainte peut aussi résulter de la dilatation thermique. Deux couches n'ayant pas le même coefficient de dilatation se dilatent différemment et entraînent des contraintes à leurs jonctions.

Or cette inclinaison et plus généralement une déformation de la structure ont plusieurs inconvénients. D'une part, elle induit une contrainte dans les jauges, qui peut ne pas être négligeable par rapport à la contrainte à la pleine échelle de mesure, ce qui a pour effet de réduire la plage de variation de la contrainte ou alors peut provoquer un dépassement de la contrainte maximale admissible.

D'autre part, une structure microélectromécanique peut comporter des butées haute et basse pour limiter la course hors-plan de la masse, afin d'éviter le dépassement des contraintes admissibles. Lorsque la masse n'est pas inclinée, elle se trouve au repos à égale distance des butées haute et basse. Or en cas d'inclinaison de la masse, les distances entre la masse et les butées haute et basse sont différentes. Si la masse est inclinée vers le support, la distance entre la masse et la butée basse est inférieure à celle entre la masse et la butée haute. Si l'inclinaison de la masse est connue, les butées pourraient être adaptées pour compenser cette différence de distance, or une telle adaptation complexifie le procédé de réalisation. En outre il est difficile de prévoir l'inclinaison de la masse.

La déformation de la structure peut également survenir en l'absence de jauges de contrainte.

Le document US 2014/0300942 décrit un micromiroir microélectromécanique comportant un corps de miroir monté mobile en rotation autour d'un axe de rotation, l'axe de rotation étant formé par une poutre ayant une faible rigidité en torsion. Des poutres de type cantilever relient le corps du miroir au support par l'intermédiaire des ressorts et assurent une rigidité en torsion autour de l'axe de rotation.

De manière générale, il est souhaitable que l'effet des contraintes internes sur la structure soit réduit.

### EXPOSÉ DE L'INVENTION

C'est par conséquent un but de la présente invention d'offrir une charnière hors-plan pour structure micro et/ou nanomécanique à sensibilité aux contraintes internes réduite.

Le but énoncé ci-dessus est atteint par une charnière hors-plan pour structure micro et/ou nanomécanique qui comporte un support, au moins une partie mobile dans une direction hors-plan ayant les caractéristiques de la revendication 1.

L'invention permet de compenser l'effet des contraintes internes libérées le long de la direction dans le plan orthogonale à l'axe de rotation, qui sont les contraintes qui ont l'action la plus gênante sur la structure. Les contraintes internes dans la direction de l'axe de rotation peuvent se libérer et les contraintes dans la direction hors-plan s'additionnent. Mais leurs contributions sur la déformation de la structure sont faibles relativement à celles des contraintes le long de la direction dans le plan orthogonale à l'axe de rotation

Ainsi la position repos de la partie mobile par rapport aux butées haute et basse est quasi-centrée, voire centrée.

Dans le cas d'une structure mettant en œuvre des jauges de contrainte, en position repos de la partie mobile, les jauges sont peu contraintes, voire ne sont pas contraintes

En d'autres termes, on réalise une articulation pivot comportant au moins un élément de flexion comprenant des poutres de flexion combinées tels qu'une auto-compensation des contraintes internes ait lieu au sein de l'élément de flexion, limitant l'effet des contraintes internes sur la structure.

De manière avantageuse, la charnière comporte deux éléments de flexion.

Dans un exemple de réalisation, la structure est mise en œuvre dans un système microélectronique et comporte des moyens de détection par exemple comprenant une ou plusieurs jauges de contraintes. Selon une caractéristique avantageuse, les moyens de détection comportent deux jauges disposées l'une par rapport à l'autre de sorte à limiter l'effet, sur la structure, des contraintes internes de la couche dans laquelle elles sont réalisées.

Dans un exemple avantageux, la structure comporte des éléments de torsion tels qu'ils limitent également l'effet des contraintes internes des poutres de torsion sur la structure.

La présente invention a alors pour objet une charnière pour structure micromécanique et/ou nanomécanique telle que définie par la revendication 1.

De préférence, les au moins première et deuxième poutres de flexion ont les mêmes dimensions.

Dans un exemple avantageux, la charnière comporte deux éléments de flexion. Par exemple, les éléments de flexion sont disposés de part et d'autre du au moins un élément de torsion.

Dans un exemple avantageux, la charnière comporte deux éléments de torsion comportant chacun une poutre de torsion alignée avec l'axe de rotation.

Selon une caractéristique additionnelle, l'élément de torsion comporte une première poutre de torsion et une deuxième poutre de torsion, et ladite poutre de torsion forme la première poutre de torsion, les premières et deuxièmes poutres de torsion étant parallèles entre elles, et reliées entre elles par au moins une de leurs extrémités longitudinales, l'une des poutres de torsion étant destinée à être reliée mécaniquement directement à la partie mobile et l'autre poutre de torsion étant destinée à être reliée mécaniquement directement au support. Dans un exemple avantageux, la charnière comporte deux paires de poutres de torsion alignées l'une par rapport à l'autre le long de l'axe de rotation.

Par exemple, la charnière est réalisée à partir d'un empilement de couches et d'étapes de gravures, dans laquelle au moins les première et deuxième poutres de flexion sont réalisées dans la même couche.

La présente invention a également pour objet une structure micromécanique et/nanomécanique comportant un support, une partie mobile dans la direction hors-plan et une charnière selon l'invention reliant la partie mobile au support.

La structure peut comporter des moyens de butée hors-plan pour la masse en éloignement et/ou en rapprochement du support.

La présente invention a également pour objet un système microélectronique comportant au moins une structure selon l'invention.

Le système microélectronique peut avantageusement comporter des moyens de détection du déplacement hors-plan de la partie mobile, comportant au moins une première jauge de contrainte, la première jauge de contrainte étant reliée mécaniquement directement au support par une première extrémité et à la partie mobile par une deuxième extrémité.

Par exemple, les moyens de détection du déplacement hors-plan de la partie mobile comportent également une deuxième jauge de contrainte, la deuxième jauge de contrainte étant reliée mécaniquement directement au support par une première extrémité et à la partie mobile par une deuxième extrémité, la première extrémité et la deuxième extrémité de la première jauge de contrainte et la première extrémité et la deuxième extrémité de la deuxième jauge de contrainte étant disposées les unes par rapport aux autres de sorte que l'orientation de la première extrémité vers la deuxième extrémité de la première jauge de contrainte est opposée à l'orientation de la première extrémité vers la deuxième extrémité de la deuxième jauge de contrainte.

### BRÈVE DESCRIPTION DES DESSINS

La présente invention sera mieux comprise sur la base de la description qui va suivre et des dessins en annexe sur lesquels:
La figure 1 est une vue de dessus et de côté d'une structure MEMS de l'état de la technique.
La figure 2 est une vue de dessus d'une structure MEMS selon un premier exemple de réalisation.
La figure 3 est une variante de réalisation de la structure de la figure 2.
La figure 4 est une vue de dessus d'un autre exemple de réalisation de structure comportant un seul élément de flexion.
La figure 5 est une vue de dessus d'un autre exemple de réalisation de structure comportant des éléments de torsion.
Les figures 6 A, 6B et 6C sont des représentations schématiques d'étapes d'un exemple de procédé de réalisation d'une structure selon l'invention.

### EXPOSÉ DÉTAILLÉ DE MODES DE RÉALISATION PARTICULIERS

La présente invention concerne les charnières pour les structures micromécaniques et/ou nanomécaniques, notamment mises en œuvre dans des systèmes MEMS et/ou NEMS appliquées par exemple à des accéléromètres, des gyromètres, des capteurs de gaz, des actionneurs...Dans la description qui va suivre la structure sera désignée structure MEMS.

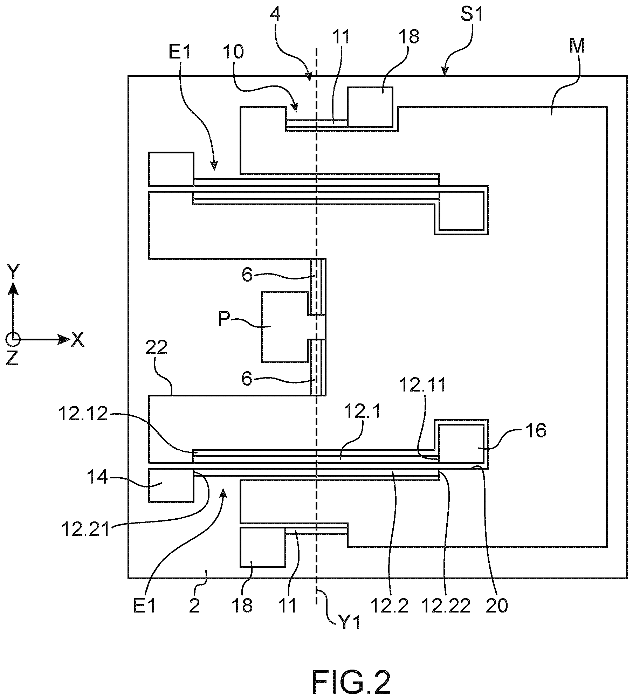

Sur la figure 2, on peut voir une représentation schématique d'une structure MEMS comportant un exemple d'une charnière selon un premier mode de réalisation.

La structure MEMS S1 comporte une partie mobile M suspendue à un support 2 au moyen d'une charnière 4 formant une articulation pivot 4.

Par exemple, la partie mobile M peut être une masse inertielle dans le cas d'un accéléromètre, ou un micromiroir ou une plateforme orientable dans le cas d'un actionneur.

La partie mobile M s'étend dans le plan de la structure défini par les axes X et Y. Le plan de la structure est le plan moyen de la structure qui correspond au plan de la feuille dans la représentation de la figure 2.

La partie suspendue est destinée à se déplacer dans une direction hors-plan Z, orthogonale aux axes X et Y.

La charnière a un axe Y1 parallèle à l'axe Y.

La charnière 4 est reliée à un bord de la partie suspendue M.

Dans l'exemple représenté, la charnière 4 comporte deux poutres 6 s'étendant le long de l'axe Y1 et destinées à être sollicitées en torsion lors du déplacement de la masse mobile dans la direction hors-plan. Chaque poutre de torsion 6 est reliée par une extrémité longitudinale à un plot d'ancrage P du support, et par une autre extrémité longitudinale à la partie mobile M.

La charnière comporte également deux éléments E1 s'étendant perpendiculairement à l'axe Y1 entre la partie mobile M et le support 2. Les éléments E1 sont destinés à être sollicités en flexion et seront désignés par la suite « éléments de flexion ».

Les deux éléments E1 ont des structures similaires, un seul de ces éléments sera décrit en détail.

L'élément de flexion E1 comporte une paire de première et deuxième poutres 12.1, 12.2 parallèles entre elles et perpendiculaires à l'axe Y1. Dans cet exemple, l'axe Y1 passe par le milieu des première et deuxième poutres.

Chaque poutre 12.1, 12.2 est reliée par une première extrémité longitudinale 12.11, 12.21 à un plot d'ancrage 14, 16 du support respectivement, et par une deuxième extrémité 12.12, 12.22 à la partie mobile M. Les poutres sont disposées tête-bêche, i.e.la première extrémité 12.11 de la première poutre et la première extrémité 12.21 de la deuxième poutre sont disposées chacune de part et d'autre l'axe de rotation Y1, ainsi que les deuxièmes extrémités 12.12 et 12.22.

Les contraintes internes à chaque poutre 12.1, 12.2, qui sont libérées lors de la fabrication, s'exercent entre la première extrémité 12.11, 12.21 reliées au support et l'extrémité 12.12, 12.22 reliée à la partie mobile.

La disposition tête-bêche des poutres 12.1, 12.2, et notamment la disposition de leur ancrage au support, ont pour conséquence que les contraintes internes dans la direction X dans la première poutre 12.1 s'exercent sur la masse dans un sens opposé à celui dans lequel s'exercent les contraintes internes dans la direction X dans la deuxième poutre 12.2. Ainsi les contraintes internes dans la direction X à la première poutre 12.1 ont une action sur la partie mobile M opposée à celle exercée par la deuxième poutre 12.2. Or, puisque les poutres ont sensiblement les mêmes caractéristiques, i.e. sensiblement les mêmes dimensions aux marges dues au procédé de réalisation, et sont réalisées dans la même couche, les contraintes internes dans la direction X dans les deux poutres sont proches ou égales et se neutralisent quasi entièrement ou entièrement. L'élément de flexion E1 n'exerce alors pas ou peu d'effort sur la partie mobile, elle n'est donc pas déformée sous l'effet de la relaxation des contraintes internes, ou alors de manière négligeable.

La structure MEMS S1 comporte également des moyens de mesure 10 du déplacement de la partie mobile. Dans cet exemple, les moyens de mesure 10 comportent des jauges 11 suspendues entre la partie mobile et des plots d'ancrage 18 du support et sont disposées dans un plan distinct d'un plan parallèle au plan XY et contenant l'axe de rotation Y1. Les jauges 11 sont disposées de sorte que, lorsqu'une jauge est sollicitée en traction, l'autre est sollicitée en compression.

Les poutres de flexion de chaque élément de flexion sont montées mécaniquement en parallèle.

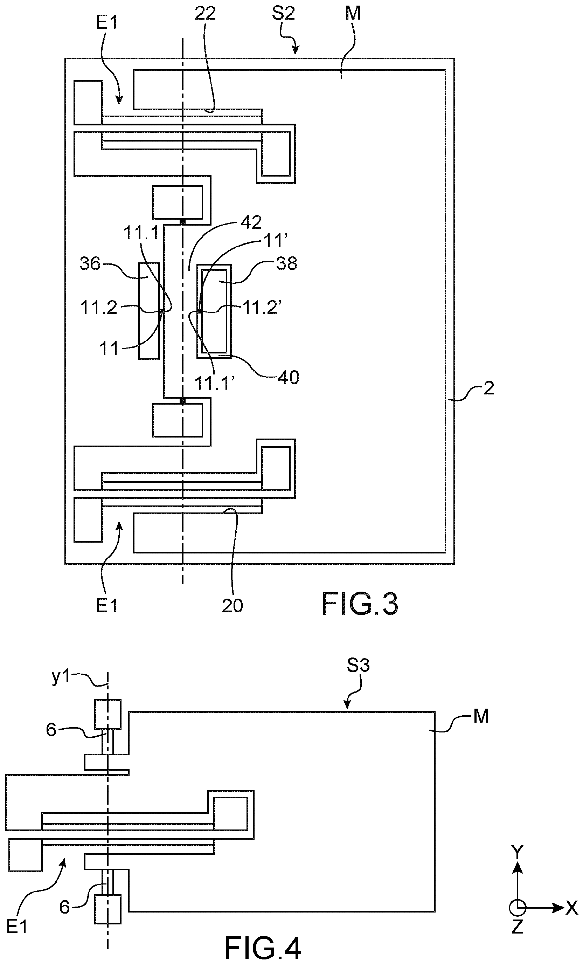

Sur la figure 3 on peut voir une variante de réalisation S2 de la structure S1, dans laquelle les jauges 11, 11' sont disposées de sorte que leurs contraintes internes se compensent, limitant l'effet de ces contraintes sur la partie mobile. Les éléments de flexion E1 sont similaires à ceux de la structure S1.

En effet il peut exister une contrainte compressive dans la couche servant à la fabrication des jauges, due à l'implantation de dopants, et qui est libérée lors de la libération des jauges. Cette contrainte peut participer à la déformation de la structure.

Sur la figure 3, les jauges 11, 11' sont alignées et sont reliées à la partie mobile et aux plots d'ancrage de sorte que les contraintes internes d'une jauge s'opposent aux contraintes internes de l'autre jauge.

La jauge 11 a une extrémité longitudinale 11.1 reliée à la partie mobile et une extrémité longitudinale 11.2 reliée à plot d'ancrage 36. La jauge 11' a une extrémité longitudinale 11.1' reliée à la partie mobile et une extrémité longitudinale 11.2' reliée à plot d'ancrage 38. Les extrémités longitudinales 11.1 et 11.1' sont en regard. Le plot d'ancrage 36 est situé dans une fenêtre 40 formée à travers la partie mobile, dont un montant 42 sert de fixation aux extrémités 11.1, 11.1' des jauges.

Chaque élément de flexion peut comporter un ensemble de plusieurs poutres de flexion, chaque ensemble assurant une auto-compensation des contraintes internes à ses poutres. La mise en œuvre de plusieurs poutres permet d'augmenter la rigidité dans le plan offerte par les éléments en flexion.

Par exemple, chaque élément de flexion peut comporter plusieurs paires de poutres de flexion, chaque paire assurant une auto-compensation des contraintes internes à ses poutres. La mise en œuvre de plusieurs poutres permet d'augmenter la rigidité dans le plan offerte par les éléments en flexion.

Selon un autre exemple, un ensemble comporte plus de deux poutres, par exemple trois poutres, deux poutres d'une première largeur compensent les contraintes de l'autre poutre d'une deuxième largeur égale à deux fois la première largeur. On peut également envisager de réaliser des ensembles avec plusieurs poutres de longueurs différentes et assurant une auto-compensation.

De plus, dans l'exemple représenté, la partie mobile est structurée de sorte à intégrer les éléments de flexion. La partie comporte des découpes 20 s'étendant parallèlement à l'axe X et logeant les plots d'ancrage et les poutres de flexion et une découpe 22 logeant les plots d'ancrage et les poutres de torsion. Cet arrangement permet d'offrir une structure compacte.

Sur la figure 4, on peut voir une structure S3 comportant un autre exemple de charnière selon le premier mode de réalisation comportant un seul élément de flexion E1. De manière avantageuse, celui-ci est aligné avec un axe de symétrie de la structure, assurant un équilibrage de la structure. Néanmoins une charnière comportant un seul élément de flexion qui ne serait pas aligné avec un axe de symétrie de la structure ne sort pas du cadre de la présente invention.

La charnière comporte également deux poutres de torsion 6 disposées de part et d'autre de l'élément de flexion E1. Dans cet exemple, la structure ne comporte pas de moyens de mesure, mais il sera compris qu'ils peuvent être agencés par exemple comme dans la structure S1 ou la structure S5.

Une charnière comportant un seul élément de flexion et une seule poutre de torsion ne sort pas du cadre de la présente invention.

Dans les exemples décrits, les moyens de mesure comportent deux jauges piézorésistives. En variante les moyens de détection comportent des jauges piézoélectriques. En variante encore, les moyens de détection comportent une ou des poutres résonantes. Pour cela, une électrode est disposée de sorte à créer une force électrostatique sur la jauge afin de la mettre en résonance. La variation de la fréquence de résonance de la jauge due à la contrainte est mesurée au moyen d'un circuit spécifique qui peut être une boucle à verrouillage de phase.

Il sera compris que les agencements des éléments de flexion par rapport aux poutres de flexion et/ou par rapport aux moyens de détection peuvent variés.

Dans les exemples décrits et de manière avantageuse, l'axe de rotation Y1 passe par le milieu des poutres de flexion. Néanmoins une charnière dans laquelle l'axe de rotation Y1 ne passerait pas par le milieu des poutres de flexion ne sort pas du cadre de la présente invention, la charnière présenterait alors une plus grande raideur hors-plan.

En variante, les poutres de flexion sont décalées l'une par rapport à l'autre dans le plan dans la direction X, i.e. leurs centres ne sont pas alignés sur l'axe Y1. La charnière présente alors une raideur en flexion augmentée.

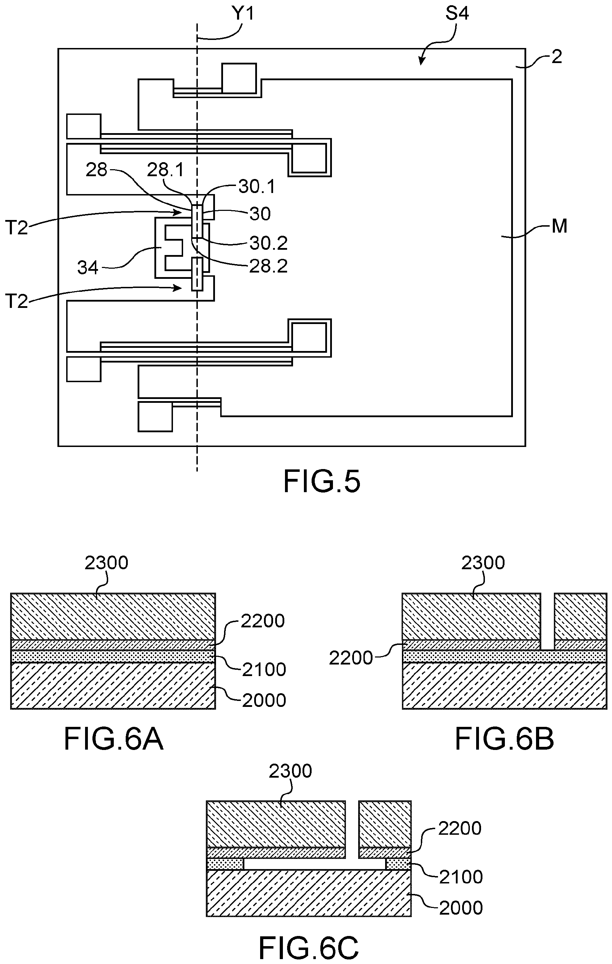

Sur la figure 5, on peut voir une structure S4 comportant une charnière dans laquelle la fonction de torsion est réalisée de manière avantageuse par des éléments de torsion, assurant un relâchement des efforts de contrainte, et ayant donc peu ou pas d'effet sur la partie mobile.

En effet, les poutres de torsion sont réalisées dans la même couche que les éléments de torsion et sont donc également les sièges de contraintes internes qui vont se relaxer lors de la libération de la structure suspendue. Cette relaxation peut par exemple provoquer un flambage des poutres.

Les éléments de torsion T2 comporte au moins une paire de poutres de torsion reliées mécaniquement entre elles en série.

Les deux éléments de torsion ont des structures similaires, seul l'un des éléments de torsion T2 sera décrit en détail.

L'élément de torsion T2 comporte une paire de poutres de torsion 28, 30 disposées parallèlement l'une par rapport à l'autre et disposées symétriquement par rapport à l'axe de rotation Y1 de sorte que leurs actions combinées définissent effectivement l'axe de rotation Y1.

Les deux poutres de torsion sont reliées l'une à l'autre directement par leurs extrémités longitudinales 28.1, 30.1 et 28.2, 30.2 respectivement de sorte à former un rectangle. La liaison entre les extrémités longitudinales 28.1, 30.1 et la liaison entre les extrémités longitudinales 28.1, 30.2 sont rigides par rapport aux poutres 28, 30. Par ailleurs la poutre de flexion 28 est reliée directement au support via un plot d'ancrage 34, par exemple au niveau de son milieu, et la poutre de flexion 30 est reliée directement à la partie mobile, par exemple au niveau de son milieu.

Les extrémités 28.1, 30.1, 28.2, 30.2 des poutres 28, 30 sont libres de se déplacer, permettant aux contraintes internes aux poutres de torsion 28, 30 de se libérer. Les contraintes de 28 et de 30 étant très proches, leurs extrémités 28.1, 30.1 et 28.2, 30.2 vont se déplacer sensiblement identiquement et la liaison rigide entre elles n'entrave pas la libération des contraintes.

Les contraintes internes ne s'appliquent alors pas sur la partie mobile. Chaque ensemble de torsion gère ses propres contraintes internes.

En variante, les poutres de torsion 28 et 30 ne sont reliées que par l'une de leurs extrémités, par exemple par les extrémités 28.2 et 30.2, et les extrémités 28.1 et 30.1 correspondent à la fixation au plot d'ancrage 234 et à la partie mobile respectivement.

Les structures décrites ci-dessus comportent avantageusement au moins une butée inférieure et/ou au moins une butée supérieure pour limiter l'amplitude de déplacement hors-plan de la partie mobile et éviter un endommagement de la structure, par exemple lorsqu'un choc extérieur est appliqué à la structure. Les butées sont de type bien connu par l'homme du métier.

Dans le cas où la structure est utilisée pour réaliser un actionneur, des moyens pour déplacer dans la direction hors-plan la partie mobile sont prévues, par exemple il s'agit de moyens électrostatiques.

En outre l'intégration des éléments de flexion, des poutres de flexion ou éléments de flexion dans la partie mobile peut être plus ou moins importante en fonction de l'espace disponible et/ou de la masse requise pour la partie mobile, ce qui permet d'offrir un grand nombre de configurations de structure pouvant s'adapter à de nombreuses applications.

Grâce à l'invention la position de la partie mobile par rapport au substrat est connue et n'est pas modifiée lors de la libération de la partie mobile.

La structure peut être réalisée par les techniques classiques de la microélectronique, sans ajouter d'étape complexe, par exemple le procédé de réalisation décrit dans le document EP2211185 peut être mis en œuvre.

Un exemple de procédé de réalisation va être décrit ci-dessous.

Par exemple, à partir d'un substrat silicium sur isolant ou SOI (Silicon On Insulate), comportant une couche 2000 de silicium, une couche 2100 d'oxyde de silicium et une couche 2200 de silicium monocristallin, le procédé comporte :
- Une étape de formation d'une couche de silicium monocristallin 2300 par exemple par dépôt par épitaxie de silicium sur la couche 2200 (figure 6A).
- Une étape de structuration des couches 2200 et 2300 par photolithographie et gravure pour délimiter la partie mobile, la ou les jauges, et la charnière comportant la ou les poutres de flexion et le ou les éléments de flexion (figure 6B). Par exemple les jauges sont réalisées uniquement dans la couche 2200. Dans ce cas, on réalise préalablement à la formation de la couche 2300, la structuration de la couche 2200 pour former la ou les jauges, par exemple par gravure, et la protection de la ou des jauges par exemple par formation et structuration d'une couche d'oxyde. Les éléments de flexion sont réalisés dans la couche 2200 et une partie de la couche 2300 et les poutres de torsion sont réalisées dans la couche 2200 et dans toute l'épaisseur de la couche 2300.
- Une étape de libération de la partie mobile et de la charnière par gravure de la couche 2100 par exemple au moyen d'acide fluorhydrique (figure 6C).

Lors du dépôt de la couche 2300, des contraintes en compression peuvent être générées dans celle-ci, notamment en cas de dopage. L'implantation de dopant dans la couche 2200 peut aussi générer des contraintes dans cette couche inférieure

Grâce à l'invention, lors de la libération de la partie mobile le relâchement des contraintes internes à la couche 2300 ne provoque pas d'inclinaison de la partie mobile mais celle-ci conserve sensiblement sa position dans le plan moyen de la structure.

Les charnières selon l'invention sont particulièrement adaptées à la réalisation de structures pour les systèmes M&NEMS utilisés dans la réalisation de capteurs ou des actionneurs.

## Revendications

1. Charnière pour structure micromécanique et/ou nanomécanique comportant un support (2), au moins une partie mobile (M) dans une direction hors-plan (Z) par rapport au support (2), ladite charnière étant destinée à suspendre la partie mobile (M) au support (2) permettant le déplacement hors-plan de la partie mobile (M), la charnière (4) comportant au moins un élément de torsion comportant au moins une poutre (6) alignée avec ou parallèle à l'axe de rotation (Y1) de la charnière, et destinée à être déformé en torsion, au moins un élément de flexion (E1) destiné être déformé en flexion, ledit élément de flexion (E1) étant destiné à relier mécaniquement la partie mobile (M) et le support (2) et comportant au moins une première poutre de flexion (12.1) et au moins une deuxième poutre de flexion (12.2) s'étendant perpendiculairement à l'axe de rotation (Y1) de la charnière (4), la première poutre de flexion (12.1) étant destinée à être reliée mécaniquement directement au support (2) par une première extrémité (12.11) et à la partie mobile (M) par une deuxième extrémité (12.12), et la deuxième poutre de flexion (12.2) étant destinée à être reliée mécaniquement directement au support (2) par une première extrémité (12.21) et à la partie mobile (M) par une deuxième extrémité (12.22), la première extrémité (12.11) et la deuxième extrémité (12.12) de la première poutre de flexion (12.1) et la première extrémité (12.21) et la deuxième extrémité (12.22) de la deuxième poutre de flexion (12.2) étant disposées les unes par rapport aux autres de sorte que l'orientation de la première extrémité (12.11) vers la deuxième extrémité (12.12) de la première poutre de flexion (12.1) est opposée à l'orientation de la première extrémité (12.21) vers la deuxième extrémité (12.22) de la deuxième poutre de flexion (12.2), **caractérisée en ce que** la première extrémité (12.11) et la deuxième extrémité (12.12) de la première poutre de flexion (12.1) sont disposées de part et d'autre de l'axe de rotation (Y1) et **en ce que** la première extrémité (12.21) et la deuxième extrémité (12.22) de la deuxième poutre de flexion (12.2) sont disposées de part et d'autre de l'axe de rotation (Y1).

2. Charnière selon la revendication 1, dans laquelle les au moins une première (12.1) et deuxième (12.2) poutres de flexion ont les mêmes dimensions.

3. Charnière selon la revendication 1 ou 2, comportant deux éléments de flexion (E1).

4. Charnière selon la revendication 3, dans laquelle les éléments de flexion (E1) sont disposés de part et d'autre du au moins un élément de torsion (6).

5. Charnière selon l'une des revendications 1 à 4, comportant deux éléments de torsion comportant chacun une poutre de torsion (6) alignée avec l'axe de rotation.

6. Charnière selon l'une des revendications 1 à 5, dans laquelle l'élément de torsion (T2) comporte une première poutre de torsion (28) et une deuxième poutre de torsion (30), et ladite poutre de torsion forme la première poutre de torsion, les premières et deuxièmes poutres de torsion étant parallèles entre elles, et reliées entre elles par au moins une de leurs extrémités longitudinales, l'une des poutres de torsion étant destinée à être reliée mécaniquement directement à la partie mobile et l'autre poutre de torsion étant destinée à être reliée mécaniquement directement au support.

7. Charnière selon la revendication 6, comportant deux paires de poutres de torsion alignées l'une par rapport à l'autre le long de l'axe de rotation.

8. Charnière selon l'une des revendications 1 à 7, comprenant un empilement de couches en partie gravées, dans laquelle au moins les première et deuxième poutres de flexion sont réalisées dans la même couche.

9. Structure micromécanique et/nanomécanique comportant un support, une partie mobile dans la direction hors-plan et une charnière selon l'une des revendications 1 à 8 reliant la partie mobile au support.

10. Structure selon la revendication 9, comportant des moyens de butée hors-plan pour la masse en éloignement et/ou en rapprochement du support.

11. Système microélectronique comportant au moins une structure selon la revendication 9 ou 10.

12. Système microélectronique selon la revendication 11, comportant des moyens de détection du déplacement hors-plan de la partie mobile, comportant au moins une première jauge de contrainte, la première jauge de contrainte étant reliée mécaniquement directement au support (2) par une première extrémité et à la partie mobile (M) par une deuxième extrémité.

13. Système microélectronique selon la revendication 12, dans lequel les moyens de détection du déplacement hors-plan de la partie mobile comportent également une deuxième jauge de contrainte, la deuxième jauge de contrainte étant reliée mécaniquement directement au support (2) par une première extrémité et à la partie mobile (M) par une deuxième extrémité, la première extrémité et la deuxième extrémité de la première jauge de contrainte et la première extrémité et la deuxième extrémité de la deuxième jauge de contrainte étant disposées les unes par rapport aux autres de sorte que l'orientation de la première extrémité vers la deuxième extrémité de la première jauge de contrainte est opposée à l'orientation de la première extrémité (12.21) vers la deuxième extrémité (12.22) de la deuxième jauge de contrainte.

## Patentansprüche

1. Scharnier für eine mikromechanische und/oder nanomechanische Struktur mit einem Träger (2), wenigstens einem in Bezug auf den Träger (2) in einer Richtung (Z) außerhalb der Ebene beweglichen Teil (M), wobei das Scharnier dazu bestimmt ist, den beweglichen Teil (M) am Träger (2) aufzuhängen, wodurch der bewegliche Teil (M) außerhalb der Ebene bewegt werden kann, wobei das Scharnier (4) wenigstens ein Torsionselement umfasst, das wenigstens einen Balken (6) umfasst, der mit der Drehachse (Y1) des Scharniers ausgerichtet oder parallel dazu ist und dazu bestimmt ist, durch Torsion verformt zu werden, wenigstens ein Biegeelement (E1), das dazu bestimmt ist, durch Biegung verformt zu werden, wobei das Biegeelement (E1) dazu bestimmt ist, den beweglichen Teil (M) und den Träger (2) mechanisch zu verbinden und wenigstens einen ersten Biegebalken (12.1) umfasst und wenigstens einen zweiten Biegebalken (12.2), der sich senkrecht zur Drehachse (Y1) des Scharniers (4) erstreckt, wobei der erste Biegebalken (12.1) dazu bestimmt ist, mit einem ersten Ende (12.11) direkt mit dem Träger (2) und mit einem zweiten Ende (12.12) mit dem beweglichen Teil (M) mechanisch verbunden zu werden, und wobei der zweite Biegebalken (12.2) dazu bestimmt ist, durch ein erstes Ende (12.21) direkt mit dem Träger (2) und durch ein zweites Ende (12.22) mit dem beweglichen Teil (M) mechanisch verbunden zu werden, wobei das erste Ende (12.11) und das zweite Ende (12.12) des ersten Biegebalkens (12.1) und das erste Ende (12.21) und das zweite Ende (12.22) des zweiten Biegebalkens (12.2) so zueinander angeordnet sind, dass die Ausrichtung des ersten Endes (12.11) zum zweiten Ende (12.12) des ersten Biegebalkens (12.1) der Ausrichtung des ersten Endes (12.21) zum zweiten Ende (12.22) des zweiten Biegebalkens (12.2) entgegengesetzt ist, **dadurch gekennzeichnet, dass** das erste Ende (12.11) und das zweite Ende (12.12) des ersten Biegebalkens (12.1) auf beiden Seiten des Drehachse (Y1) angeordnet sind und dass das erste Ende (12.21) und das zweite Ende (12.22) des zweiten Biegebalkens (12.2) auf beiden Seiten des Drehachse (Y1) angeordnet sind

2. Scharnier nach Anspruch 1, wobei der wenigstens eine erste (12.1) und zweite (12.2) Biegebalken die gleichen Abmessungen aufweisen.

3. Scharnier nach Anspruch 1 oder 2, umfassend zwei Biegeelemente (E1).

4. Scharnier nach Anspruch 3, wobei die Biegeelemente (E1) auf beiden Seiten des wenigstens einen Torsionselements (6) angeordnet sind.

5. Scharnier nach einem der Ansprüche 1 bis 4, umfassend zwei Torsionselemente, die jeweils einen mit der Drehachse ausgerichteten Torsionsbalken (6) aufweisen.

6. Scharnier nach einem der Ansprüche 1 bis 5, wobei das Torsionselement (T2) einen ersten Torsionsbalken (28) und einen zweiten Torsionsbalken (30) umfasst und wobei der Torsionsbalken den ersten Torsionsbalken bildet, wobei der erste und der zweite Torsionsbalken parallel zueinander sind, und über wenigstens eines ihrer Längsenden miteinander verbunden sind, wobei einer der Torsionsbalken dazu bestimmt ist, mechanisch direkt mit dem beweglichen Teil verbunden zu sein, und der andere Torsionsträger dazu bestimmt ist, mechanisch direkt mit dem Träger verbunden zu sein.

7. Scharnier nach Anspruch 6, welches zwei Paare von Torsionsbalken umfasst, die entlang der Drehachse zueinander ausgerichtet sind.

8. Scharnier nach einem der Ansprüche 1 bis 7, umfassend einen Stapel von teilweise geätzten Lagen, wobei wenigstens der erste und der zweite Torsionsbalken in derselben Lage hergestellt sind.

9. Mikromechanische und/oder nanomechanische Struktur, umfassend einen Träger, einen in Richtung außerhalb der Ebene beweglichen Teil und ein Scharnier nach einem der Ansprüche 1 bis 8, das den beweglichen Teil mit dem Träger verbindet.

10. Struktur nach Anspruch 9, umfassend Mittel zur Anlage der Masse außerhalb der Ebene, weg von und/oder hin zu dem Träger.

11. Mikroelektronisches System, umfassend wenigstens eine Struktur nach Anspruch 9 oder 10.

12. Mikroelektronisches System nach Anspruch 11, umfassend Mittel zum Erfassen der Bewegung des beweglichen Teils außerhalb der Ebene, die wenigstens ein erstes Dehnungsmesselement umfassen, wobei das erste Dehnungsmesselement mit einem ersten Ende direkt mit dem Träger (2) und mit einem zweiten Ende mit dem beweglichen Teil (M) mechanisch verbunden ist.

13. Mikroelektronisches System nach Anspruch 12, wobei die Mittel zum Erfassen der Bewegung des beweglichen Teils außerhalb der Ebene auch ein zweites Dehnungsmesselement umfassen, wobei das zweite Dehnungsmesselement mit einem ersten Ende direkt mit dem Träger (2) und mit einem zweiten Ende mit dem beweglichen Teil (M) mechanisch verbunden ist, wobei das erste Ende und das zweite Ende des ersten Dehnungsmesselements und das erste Ende und das zweite Ende des zweiten Dehnungsmesselements relativ zueinander so angeordnet sind, dass die Ausrichtung des ersten Endes zum zweiten Ende des ersten Dehnungsmesselements der Ausrichtung des ersten Endes entgegengesetzt ist (12.21) hin zu dem zweiten Ende (12.22) des zweiten Dehnungsmesselements.

## Claims

1. Hinge for a micromechanical and/or nanomechanical structure comprising a support (2), at least one movable part (M) in an out-of-plane direction (Z) with respect to the support (2), said hinge being intended to suspend the movable part (m) from the support (2) allowing for the out-of-plane displacement of the movable part (M), the hinge (4) comprising at least one torsion element comprising at least one beam (6) aligned with or parallel to the axis (Y1) of rotation of the hinge, and intended to be deformed in torsion, at least one bending element (E1) intended to be deformed in bending, said bending element (E1) being intended to mechanically connect the movable part (M) and the support (2) and comprising at least one first bending beam (12.1) and at least one second bending beam (12.2) extending perpendicularly to the axis of rotation (Y1) of the hinge (4), the first bending beam (12.1) being intended to be mechanically connected directly to the support (2) by a first end (12.11) and to the movable part (M) by a second end (12.12), and the second bending beam (12.2) being intended to be mechanically connected directly to the support (2) by a first end (12.21) and to the movable part (M) by a second end (12.21), the first end (12.11) and the second end (12.12) of the first bending beam (12.1) and the first end (12.21) and the second end (12.22) of the second bending beam (12.2) being disposed with respect to one another in such a way that the orientation of the first end (12.21) towards the second end (12.22) of the first bending beam (12.1) is opposed to the orientation of the first end (12.21) towards the second end (12.22) of the second bending beam (12.2), **characterised in that** the first end (12.11) and the second end (12.12) of the first bending beam (12.1) are located on each side of the axis of rotation (Y1) and the first end (12.21) and the second end (12.22) of the second bending beam (12.2) are located on each side of the axis of rotation (Y1).

2. Hinge according to claim 1, wherein the at least one first (12.1) and second (12.2) bending beams have the same dimensions.

3. Hinge according to claim 1 or 2, comprising two bending elements (E1).

4. Hinge according to claim 3, wherein the bending elements (E1) are disposed on either side of the at least one torsion element (6).

5. Hinge according to any of claims 1 to 4, comprising two torsion elements each comprising a torsion beam (6) aligned with the axis of rotation.

6. Hinge according to any of claims 1 to 5, wherein the torsion element (T2) comprises a first torsion beam (28) and a second torsion beam (30), and said torsion beam forms the first torsion beam, the first and second torsion beams being parallel to one another, and connected together by at least one of the longitudinal ends thereof, one of the torsion beams being intended to be mechanically connected directly to the movable part and the other torsion beam being intended to be mechanically connected directed to the support.

7. Hinge according to claim 6, comprising two pairs of torsion beams aligned relative to each other along the axis of rotation.

8. Hinge according to any of claims 1 to 7, comprising a stack of layers partly etched, wherein at least the first and second bending beams are made in the same layer.

9. Micromechanical and/or nanomechanical structure comprising a support, a movable part in the out-of-plane direction and a hinge according to any of claims 1 to 8 connecting the movable part to the support.

10. Structure according to claim 9, comprising at least one out-of-plane abutment for the mass moving away from and/or moving towards the support.

11. Microelectronic system comprising at least one structure according to claim 9 or 10.

12. Microelectronic system according to claim 11, comprising detection means for detecting the out-of-plane displacement of the movable part, comprising at least one first stress gauge, the first stress gauge being mechanically connected directly to the support (2) by a first end and to the movable part (M) by a second end.

13. Microelectronic system according to claim 12, wherein the detection means for detecting the out-of-plane displacement of the movable part also comprises a second stress gauge, the second stress gauge being mechanically connected directly to the support (2) by a first end and to the movable part (M) by a second end, the first end and the second end of the first stress gauge and the first end and the second end of the second stress gauge being disposed with respect to one another in such a way that the orientation of the first end towards the second end of the first stress gauge is opposed to the orientation of the first end (12.21) towards the second end (12.22) of the second stress gauge.
